# EUROPEAN PATENT APPLICATION

(11) **EP 4 819 493 A1**
(43) Date of publication of application: **07.10.2026**
(21) Application number: 26167080.6
(22) Date of filing: 24.03.2026
(51) Int. Cl.: H03K 17/955, H03K 17/96

(54) **CAPACITANCE SENSOR AND SENSING DEVICE**

(30) Priority: 28.03.2025 JP 2025055269; 20.01.2026 JP 2026007197
(71) Applicant: Seiko Epson Corporation, Tokyo 160-8801 (JP)
(72) Inventor: ICHIKAWA, Ryosuke, Suwa-shi, Nagano, 392-8502 (JP); ITO, Hisahiro, Suwa-shi, Nagano, 392-8502 (JP); OTA, Tatsuya, Suwa-shi, Nagano, 392-8502 (JP); HIGUCHI, Teppei, Suwa-shi, Nagano, 392-8502 (JP)
(74) Representative: MERH-IP Matias Erny Reichl Hoffmann Patentanwälte PartG mbB

(57) **Abstract**

A capacitance sensor connected to a sensing electrode forming a first capacitance between the sensing electrode and a first conductor includes a package, a sensing terminal disposed in the package and electrically connected to the sensing electrode, and an oscillation circuit included in the package. The oscillation circuit includes an amplifier and a resonator connected between an input node and an output node of the amplifier. The sensing terminal is connected to one of the input node and the output node of the amplifier. When a grounded second conductor approaches the first conductor, a second capacitance is formed between the first conductor and the second conductor, and the first capacitance and the second capacitance are connected in series between the sensing electrode and the ground so that an oscillation frequency of the oscillation circuit is changed.

## Description

The present application is based on, and claims priority from JP Application Serial Number 2025-055269, filed March 28, 2025, the disclosure of which is hereby incorporated by reference herein in its entirety.

### BACKGROUND

### 1. Technical Field

The present disclosure relates to a capacitance sensor and a sensing device.

### 2. Related Art

JP-A-2021-99297 discloses a capacitive touch sensor including a conductive metal sheet functioning as a counter electrode, a detection electrode that is disposed in the vicinity of the metal sheet and electrically insulated from the metal sheet, a capacitance detection circuit that is electrically connected to the detection electrode and includes a current detector, and a power source that supplies electric power to the capacitance detection circuit. A total value Cs, which is a sum of a first capacitance Cs1 that is a capacitance between the metal sheet and an object to be detected and a second capacitance Cs2 that is a capacitance between the metal sheet and the detection electrode, is detected by the current detector. According to the capacitive touch sensor described in JP-A-2021-99297, when the current detector detects a current I corresponding to the total value Cs of the first capacitance Cs1 and the second capacitance Cs2 expressed by Expression (1), it is possible to determine that the object to be detected comes into contact with or approaches the metal sheet. In Expression (1), V_{DD} is a power supply voltage, and F is a switching frequency for alternately switching a charging system and a discharging system with respect to the detection electrode. $I = 2 πCs \times {V}_{DD} \times F$ (1)

However, the capacitive touch sensor described in JP-A-2021-99297 is a current detection type, and in order to increase the detection capability, it is necessary to increase the power supply voltage V_{DD} and the switching frequency F, which increases power consumption.

### SUMMARY

According to an aspect of the present disclosure, a capacitance sensor connected to a sensing electrode forming a first capacitance between the sensing electrode and a first conductor includes a package, a sensing terminal disposed in the package and electrically connected to the sensing electrode, and an oscillation circuit included in the package. The oscillation circuit includes an amplifier and a resonator connected between an input node and an output node of the amplifier. The sensing terminal is connected to one of the input node and the output node of the amplifier. When a grounded second conductor approaches the first conductor, a second capacitance is formed between the first conductor and the second conductor, and the first capacitance and the second capacitance are connected in series between the sensing electrode and the ground so that an oscillation frequency of the oscillation circuit is changed.

According to another aspect of the present disclosure, a sensing device includes the capacitance sensor according to the aspect and the sensing electrode.

### BRIEF DESCRIPTION OF THE DRAWINGS

FIG. 1 is a diagram illustrating an appearance of a sensing device.
FIG. 2 is a plan view illustrating an example of an internal structure of a capacitance sensor.
FIG. 3 is a plan view illustrating another example of the internal structure of the capacitance sensor.
FIG. 4 is a diagram illustrating an example of use of the sensing device.
FIG. 5 is a functional block diagram illustrating the sensing device.
FIG. 6 is a diagram illustrating an example of a configuration of a drive circuit and a buffer circuit.
FIG. 7 is a diagram illustrating an equivalent circuit of a resonator.
FIG. 8 is a graph illustrating an example of a relationship between a capacitance value C_{L} of a load capacitance and a normalized frequency Δf/f₀.
FIG. 9 is a timing chart of various signals.
FIG. 10 is a diagram illustrating a comparison of a frequency variable characteristic with respect to the capacitance value C_{L} of the load capacitance between an LC oscillation circuit and an oscillation circuit using a resonator.

### DESCRIPTION OF EMBODIMENTS

Hereinafter, a preferred embodiment of the present disclosure will be described in detail with reference to the drawings. It should be noted that the embodiment described below does not unduly limit the contents of the present disclosure described in the appended claims. In addition, all configurations described below are not necessarily essential components of the present disclosure.

### 1. First Embodiment

### 1-1. Structure of Sensing Device

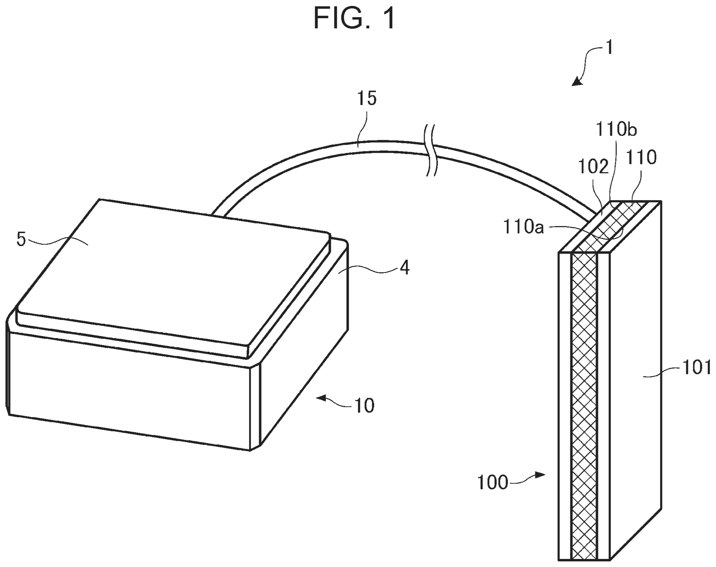

FIG. 1 is a diagram illustrating an appearance of a sensing device 1 of this embodiment. As illustrated in FIG. 1, the sensing device 1 of this embodiment includes a capacitance sensor 10, a sensing section 100, and a cable 15 that connects the capacitance sensor 10 and the sensing section 100.

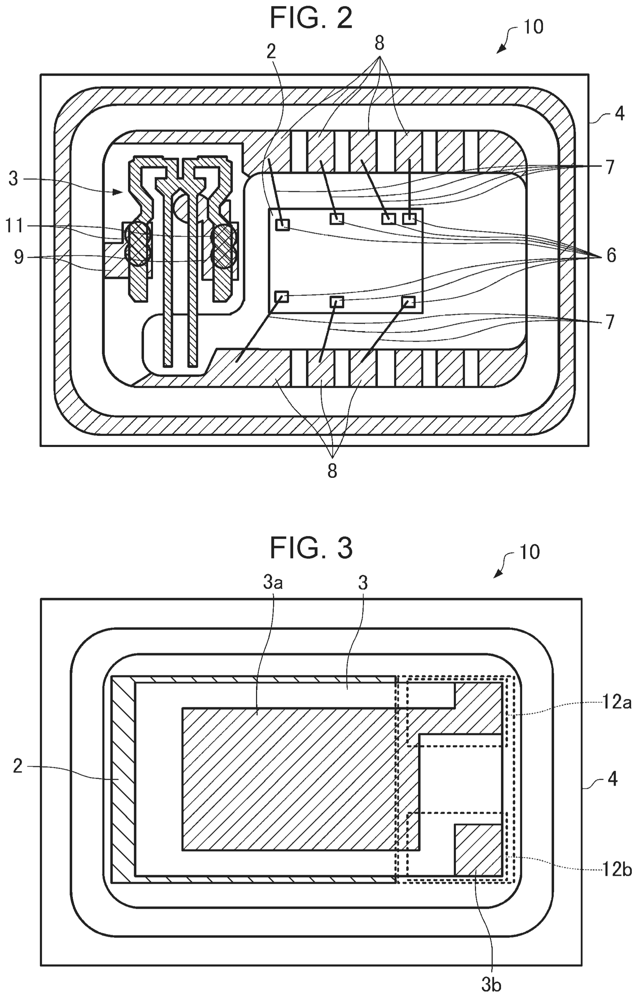

FIG. 2 is a plan view illustrating an example of an internal structure of the capacitance sensor 10. As illustrated in FIGS. 1 and 2, the capacitance sensor 10 includes a circuit device 2, a resonator 3, a package 4, and a lid 5. In FIG. 2, illustration of the lid 5 is omitted.

The capacitance sensor 10, for example, has a single seal structure, and the package 4 is a container that accommodates the circuit device 2 and the resonator 3 in the same space. That is, the circuit device 2 and the resonator 3 are installed inside the package 4. Specifically, a recessed portion is formed in the package 4, and the circuit device 2 and the resonator 3 are accommodated in the recessed portion being covered with the lid 5. Note that the capacitance sensor 10 may not have a single seal structure. For example, the package 4 may be a container that accommodates the circuit device 2 and the resonator 3 in different spaces. Specifically, the package 4 may have two recessed portions on opposite surfaces, the resonator 3 may be accommodated in one of the recessed portions being covered with the lid 5, and the circuit device 2 may be accommodated in the other recessed portion being covered with a sealing member.

In this embodiment, the circuit device 2 is realized by a one-chip integrated circuit. However, at least a portion of the circuit device 2 may be constituted by discrete components. In the example of FIG. 2, the circuit device 2 is mounted on an inner bottom surface of the package 4 by using an adhesive or the like such that a surface on which a plurality of pads 6 are formed serves as an upper surface. Each of the plurality of pads 6 is connected to a corresponding one of a plurality of electrodes 8 formed on a surface of the recessed portion of the package 4 by a corresponding one of bonding wires 7.

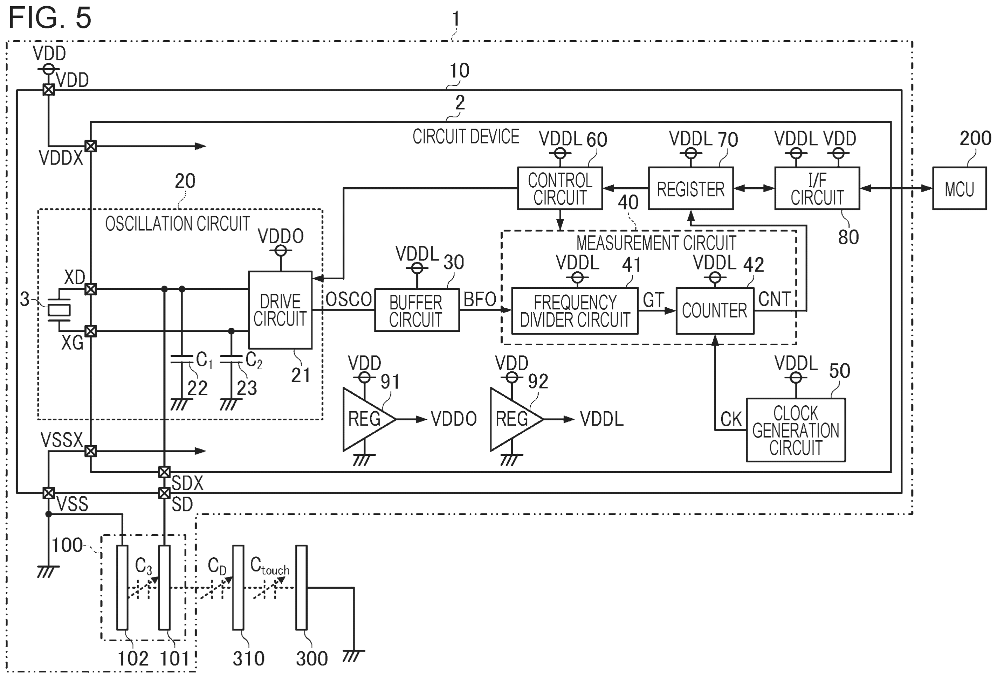

The resonator 3 is a piezoelectric resonator using, as a substrate material, a piezoelectric material including a piezoelectric single crystal, such as quartz crystal, lithium tantalate, or lithium niobate, and a piezoelectric ceramic, such as lead zirconate titanate. Alternatively, the resonator 3 is a micro electro mechanical systems (MEMS) resonator which uses a silicon substrate or the like as a substrate material and is excited by electrostatic attractive force. For example, the resonator 3 is a quartz crystal resonator using quartz crystal as a substrate material, and is a tuning fork type quartz crystal resonator in the example of FIG. 2. Two support arms of the resonator 3 are bonded to respective two electrodes 9 formed on the surface of the recessed portion of the package 4 by conductive bonding members 11. That is, the support arms of the resonator 3 are fixed to and electrically connected to the corresponding electrodes 9. The two electrodes 9 are electrically connected to two of the electrodes 8 and two of the pads 6 of the circuit device 2, specifically, an XD terminal and an XG terminal of FIG. 5 to be described later, respectively, by wiring lines disposed in the package 4.

Electrode patterns (not illustrated) are formed on two support arms and two vibrating arms of the resonator 3, respectively. Then, a signal generated in one of the electrode patterns on a first side is supplied from a corresponding one of the electrodes 8 to the XG terminal of the circuit device 2, an amplifier included in the circuit device 2 amplifies the signal, and the amplified signal is supplied from the XD terminal to the resonator 3 via one of the electrodes 9 on a second side, whereby the two vibrating arms of the resonator 3 continue to vibrate like a tuning fork. Thus, an oscillation circuit including the resonator 3 and the amplifier oscillates.

FIG. 3 is a plan view illustrating another example of the internal structure of the capacitance sensor 10. In the example of FIG. 3, the circuit device 2 is mounted on a bottom surface of the recessed portion of the package 4, and the resonator 3 is mounted over the circuit device 2 with a gap interposed therebetween.

In the example of FIG. 3, the resonator 3 is an AT cut quartz crystal resonator. The resonator 3 has metal excitation electrodes 3a and 3b on a front surface and a rear surface thereof, and vibrates at a desired frequency corresponding to a shape and a mass of the resonator 3 including the excitation electrodes 3a and 3b. The excitation electrodes 3a and 3b are bonded to two electrodes 12a and 12b, respectively, formed on a surface of the recessed portion of the package 4. The package 4 includes wiring lines (not illustrated) for electrically connecting the two terminals of the circuit device 2, that is, the XD and XG terminals of FIG. 5 to be described later and the electrodes 12a and 12b to each other. Then, a signal generated in one of the excitation electrodes 3a and 3b is supplied to the XG terminal of the circuit device 2, the amplifier included in the circuit device 2 amplifies the signal, and the amplified signal is supplied from the XD terminal to the resonator 3 via the other of the excitation electrodes 3a and 3b, whereby thickness-shear vibration in which a front surface and a back surface of the resonator 3 move in opposite directions to each other is continued. Thus, the oscillation circuit including the resonator 3 and the amplifier oscillates.

In the capacitance sensor 10, a plurality of external connection terminals (not illustrated) are disposed on the back surface of the package 4 which is a bottom surface. Furthermore, the package 4 includes wiring lines (not illustrated) for electrically connecting the individual terminals of the circuit device 2 and the external connection terminals disposed on the bottom surface of the package 4.

As illustrated in FIG. 1, the sensing section 100 is provided outside the package 4 of the capacitance sensor 10, and is connected to the capacitance sensor 10 by the cable 15. For example, the cable 15 may be a coaxial cable, a flexible flat cable, or the like.

The sensing section 100 includes a substrate 110 having a surface 110a and a surface 110b which is a back surface of the surface 110a. A rectangular electrode 101 is disposed on the surface 110a of the substrate 110. On the surface 110b of the substrate 110, an electrode 102 is disposed at a position facing a region of arrangement of the electrode 101 on the surface 110a. For example, the electrode 102 is disposed on substantially an entire surface of the surface 110b. Examples of the substrate 110 include, but are not limited to, a polyimide substrate, a glass epoxy substrate, a glass composite substrate, a Teflon substrate, an alumina substrate, a low temperature co-fired ceramics (LTCC) substrate, and a build-up substrate. In addition, any of a rigid substrate using a hard insulator base material, a flexible substrate using a thin and flexible insulator base material, and a rigid-flexible substrate combining features of the rigid substrate and the flexible substrate can be used.

The capacitance sensor 10 is connected to the electrodes 101 and 102. That is, each of the electrodes 101 and 102 is connected to the external connection terminal of the capacitance sensor 10 by the wiring lines included in the cable 15. Therefore, the electrodes 101 and 102 are individually connected to the terminals of the circuit device 2 via the external connection terminals of the capacitance sensor 10.

In this embodiment, the electrode 101 is a sensing electrode which is connected to one of the XD terminal and the XG terminal of the circuit device 2 and is used for sensing. The electrode 102 is a ground electrode which is connected to a ground terminal of the circuit device 2 and of which a potential is fixed to a ground potential.

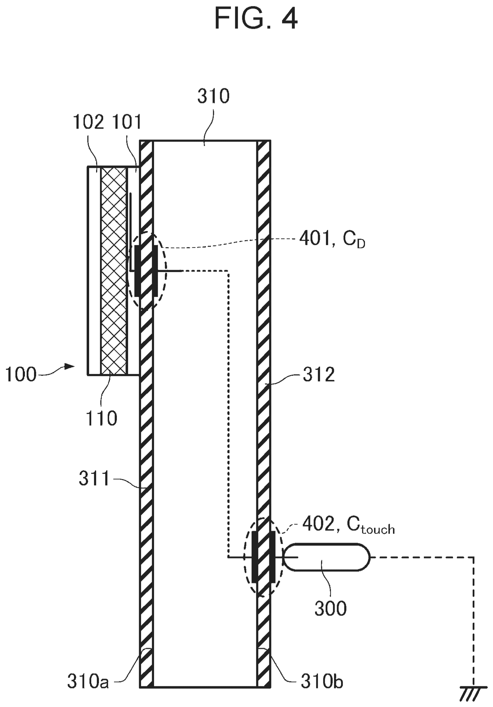

As illustrated in FIG. 4, the electrode 101 of the sensing section 100 is mounted on an insulator 311. The insulator 311 is disposed on a surface 310a of a conductor 310, and an insulator 312 is disposed on a surface 310b of the conductor 310 opposite to the surface 310a. Therefore, a capacitance 401 having a capacitance value of C_{D} is formed between the electrode 101 and the conductor 310. For example, the conductor 310 may be an object made of a metal, such as iron or aluminum.

In this state, when a grounded conductor 300 approaches the conductor 310, that is, when the conductor 300 comes into contact with or approaches the insulator 312, a capacitance 402 having a capacitance value of C_{touch} is formed between the conductor 310 and the conductor 300. As a result, the capacitance 401 and the capacitance 402 are connected in series between the electrode 101 and the ground. Note that the conductor 300 may be directly grounded, or may be indirectly grounded via another conductor.

As described above, since the electrode 101 is connected to one of the XD terminal and the XG terminal of the circuit device 2, a combined capacitance of the capacitance 401 and the capacitance 402 is a load capacitance of the oscillation circuit including the resonator 3 and the amplifier. A capacitance value C_{L}' of the combined capacitance is expressed by Expression (2). ${C}_{L} ′ = \frac{{C}_{D} {C}_{touch}}{{C}_{D} + {C}_{touch}}$ (2)

According to Expression (2), since the capacitance 401 and the capacitance 402 are connected in series between the electrode 101 and the ground, the combined capacitance of the capacitance 401 and the capacitance 402 serves as a load capacitance, and thus an oscillation frequency f of the oscillation circuit changes. To be specific, since C_{L}' ≈ 0 is satisfied until the conductor 300 approaches the conductor 310, when the conductor 300 approaches the conductor 310, the load capacitance increases, and the oscillation frequency f of the oscillation circuit decreases.

As will be described later, the circuit device 2 measures the oscillation frequency f and outputs a measurement value of the oscillation frequency f to the outside of the capacitance sensor 10. Therefore, the external device can detect the presence or absence of the conductor 300 approaching the conductor 310 based on the measurement value of the oscillation frequency f output from the capacitance sensor 10.

In FIG. 4, the capacitance 402 is generated when the conductor 300 comes into contact with or approaches the insulator 312, but may be generated when the conductor 300 comes into contact with or approaches the insulator 311. Also in this case, since the capacitance 401 and the capacitance 402 are connected in series between the electrodes 101 and the ground, the capacitance value C_{L}' of the combined capacitance of the capacitance 401 and the capacitance 402 is expressed by Expression (2). Furthermore, in FIG. 4, the conductor 300 may not be disposed. In this case, a ground capacitance of the conductors 310 is the capacitance value C_{touch}. That is, the ground capacitance of the conductor 310 may be changed when an object made of a semiconductor or the like comes into contact with or approaches a surface of the insulator 312 which is opposite to the conductor 310.

Note that the sensing section 100 includes the electrode 102 at the ground potential so that the capacitance value C_{touch} of the capacitance 402 does not change too much when the conductor 300 approaches the conductor 310. Furthermore, the electrode 102 also functions, when a conductor which is not a detection target approaches the electrode 101 from a direction facing the surface 110b of the substrate 110, as a shield member for reducing a change in the capacitance value C_{L}' due to the conductor.

As an example, the sensing device 1 can be used in a vehicle theft detection system. In this system, for example, the electrode 101 of the sensing section 100 is mounted on an inner surface of a door of a vehicle. Since the door of the vehicle has a configuration in which both surfaces of a metal plate are coated with paint, the metal plate included in the door corresponds to the conductor 310, the paint attached to the inner surface of the metal plate corresponds to the insulator 311, and the paint attached to the outer surface of the metal plate corresponds to the insulator 312. For example, when a thief approaches the vehicle by walking on the ground, the thief approaching the door corresponds to the conductor 300. For example, when a finger or a tool of the thief touches or approaches the door, the capacitance 401 and the capacitance 402 are connected in series between the electrode 101 and the ground, and the oscillation frequency f changes. Accordingly, an owner of the vehicle controls ON/OFF of a detection operation, whereby a theft detection system for detecting an approach of a person other than the owner, such as a thief, is realized. Since the sensing section 100 can be attached to an arbitrary position of the door of the vehicle, it is difficult for the thief to specify the attachment position. For example, a warning device may detect the approach of the thief based on a change in the oscillation frequency f and generate a warning sound to the thief, or may notify an information terminal owned by the owner of the vehicle of the detection of the approach.

Note that the conductor 300 is a person in this example but not limited thereto, and may be an arbitrary conductor, such as an animal or a key. Furthermore, in this example, the conductor 310 is the metal plate included in the door of the vehicle, but is not limited thereto, and may be an arbitrary conductor, such as a metal portion of a key of a door or a window of a house. In a case where the electrode 101 of the sensing section 100 is attached to a key of a door or a window of a house, a system that detects intrusion of a burglar into the house and performs a warning to the burglar or notification to an information terminal owned by a resident is realized.

### 1-2. Constructive Configuration of Sensing Device

FIG. 5 is a functional block diagram of the sensing device 1 of this embodiment. As illustrated in FIG. 5, the sensing device 1 of this embodiment includes the capacitance sensor 10 and the sensing section 100.

The capacitance sensor 10 includes a VDD terminal, a VSS terminal, and an SD terminal. The VDD terminal is a power supply terminal to which a power supply voltage VDD is supplied from the outside of the capacitance sensor 10. The VSS terminal is a ground terminal which is connected to the ground outside the capacitance sensor 10 and to which a ground voltage is supplied. Furthermore, the VSS terminal is electrically connected to the electrode 102 of the sensing section 100. The SD terminal is a sensing terminal electrically connected to the electrode 101 of the sensing section 100. The capacitance sensor 10 further includes a communication terminal (not illustrated) for performing data communication with an MCU 200, which is an external device. The terminals including the VDD terminal, the VSS terminal, and the SD terminal are external connection terminals disposed in the package 4, and are disposed, for example, on the bottom surface of the package 4. As described above, the capacitance sensor 10 includes the circuit device 2 and the resonator 3.

The circuit device 2 includes a VDDX terminal, a VSSX terminal, and an SDX terminal. The VDDX terminal is electrically connected to the VDD terminal, and is a power supply terminal to which the power supply voltage VDD is supplied via the VDD terminal. The VSSX terminal is electrically connected to the VSS terminal, and is a ground terminal to which the ground voltage is supplied via the VSS terminal. Furthermore, the VSSX terminal is electrically connected to the electrode 102 of the sensing section 100 via the VSS terminal. The SDX terminal is electrically connected to the SD terminal, and is a sensing terminal electrically connected to the electrode 101 of the sensing section 100 via the SD terminal. Moreover, the circuit device 2 includes the XD terminal and the XG terminal which are electrically connected to respective ends of the resonator 3. The circuit device 2 further includes communication terminals (not illustrated) for performing data transmission with the MCU 200 which is the external device of the circuit device 2, and these communication terminals are connected to the communication terminals of the capacitance sensor 10.

The circuit device 2 includes a drive circuit 21, a buffer circuit 30, a measurement circuit 40, a clock generation circuit 50, a control circuit 60, a register 70, an interface circuit 80, and regulators 91 and 92. Note that the circuit device 2 may have a configuration in which some of these components are omitted or changed, or other components are added.

The regulator 91 steps down the power supply voltage VDD supplied from the VDDX terminal to a power supply voltage VDDO lower than the power supply voltage VDD. Furthermore, the regulator 92 steps down the power supply voltage VDD supplied from the VDDX terminal to a power supply voltage VDDL lower than the power supply voltage VDD. In this case, for example, in the regulator 92, the power supply voltage VDD is 1.5 V to 5.5 V, the power supply voltage VDDO is 1 V, and the power supply voltage VDDL is 1.4 V. Alternatively, the regulator 92 may boost the power supply voltage VDD to a power supply voltage VDDL higher than the power supply voltage VDD. In this case, for example, in the regulator 92, the power supply voltage VDD is 1.2 V to 5.5 V, the power supply voltage VDDO is 1 V, and the power supply voltage VDDL is 1.4 V.

The drive circuit 21 operates by being supplied with the power supply voltage VDDO, and the buffer circuit 30, the measurement circuit 40, the clock generation circuit 50, the control circuit 60, and the register 70 operate by being supplied with the power supply voltage VDDL. The interface circuit 80 operates by being supplied with the power supply voltage VDDL, and is also supplied with the same power supply voltage VDD as the MCU 200 in order to perform data communication with the MCU 200.

The drive circuit 21 is electrically connected to the XD terminal and the XG terminal, and vibrates the resonator 3 to generate an oscillation signal OSCO. The drive circuit 21 amplifies a signal input from the resonator 3 via the XG terminal and outputs the amplified signal to the resonator 3 via the XD terminal. Accordingly, the two vibrating arms of the resonator 3 vibrate, and the drive circuit 21 outputs a signal input from the resonator 3 via the XG terminal as the oscillation signal OSCO. The resonator 3 and the drive circuit 21 constitute an oscillation circuit 20.

The buffer circuit 30 buffers the oscillation signal OSCO output from the drive circuit 21 and outputs a signal BFO of a rectangular wave. Note that examples of the rectangular wave of the signal BFO include not only a strict rectangular wave but also a waveform close to a rectangular wave.

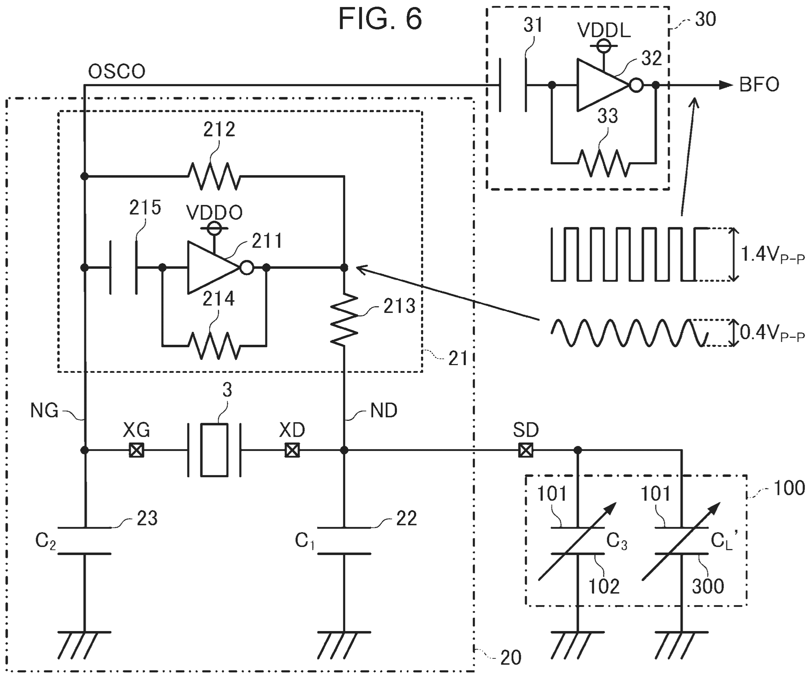

FIG. 6 is a diagram illustrating an example of a configuration of the drive circuit 21 and the buffer circuit 30. As illustrated in FIG. 6, the drive circuit 21 includes an amplifier 211, resistors 212, 213, and 214, and a capacitor 215.

An input terminal of the amplifier 211 is connected to one end of the resistor 214 and one end of the capacitor 215. An output terminal of the amplifier 211 is connected to one end of the resistor 213, the other end of the resistor 214, and one end of the resistor 212. The other end of the resistor 213 is connected to a node ND. The other end of the capacitor 215 is connected to the other end of the resistor 212 and a node NG. The resonator 3 is connected between the node NG and the node ND. The node NG is connected to the XG terminal, and the node ND is connected to the XD terminal. Therefore, the resonator 3 is connected between the node NG and the node ND.

The node NG is an input node of the amplifier 211, and a signal output from the resonator 3 is input to the amplifier 211 from the node NG via the capacitor 215. The amplifier 211 operates by being supplied with the power supply voltage VDDO, and outputs a signal obtained by amplifying the signal. The node ND is an output node of the amplifier 211, and a signal output from the amplifier 211 is output to the node ND via the resistor 213. In the example of FIG. 6, the amplifier 211 is a CMOS inverter circuit, but may be a bipolar transistor.

The signal output from the amplifier 211 is input to the resonator 3 from the node ND. A voltage amplitude of the signal output from the amplifier 211 is lower than the power supply voltage VDDO. For example, the power supply voltage VDDO is 1 V, whereas a voltage amplitude of the signal output from the amplifier 211 is approximately 0.4 V_{P-P}. Therefore, the power consumed by the oscillation circuit 20 is reduced as compared with a case where the signal output from the amplifier 211 is a rectangular wave signal having a voltage amplitude of the power supply voltage VDDO.

As illustrated in FIGS. 2 and 3, the resonator 3 is, for example, a tuning fork type quartz crystal resonator or an AT cut quartz crystal resonator, and has a very high Q value, and thus the signal output from the resonator 3 has little noise and is close to a sine wave. The signal output from the resonator 3 to the node NG is input to the buffer circuit 30 as the oscillation signal OSCO.

An SD terminal is connected to one of the node NG and the node ND. Therefore, the electrode 101 of the sensing section 100 is electrically connected to one of the node NG and the node ND through the SD terminal. In FIGS. 5 and 6, the SD terminal is connected to the node ND, and the electrode 101 of the sensing section 100 is electrically connected to the node ND through the SD terminal. Therefore, as described above, when the grounded conductor 300 approaches the conductor 310, a combined capacitance of the capacitance 401 and the capacitance 402 is a load capacitance of the oscillation circuit 20. Note that the SD terminal may be connected to the node NG, and the electrode 101 of the sensing section 100 may be electrically connected to the node NG via the SD terminal.

The buffer circuit 30 includes a capacitor 31, a CMOS inverter circuit 32, and a resistor 33. An input terminal of the CMOS inverter circuit 32 is connected to one end of the resistor 33 and one end of the capacitor 31. An output terminal of the CMOS inverter circuit 32 is connected to the other end of the resistor 33. The other end of the capacitor 31 is connected to the node NG. In the buffer circuit 30 configured as described above, the oscillation signal OSCO output from the drive circuit 21 is input to the CMOS inverter circuit 32 via the capacitor 31. The CMOS inverter circuit 32 operates by being supplied with the power supply voltage VDDL, inverts and amplifies the oscillation signal OSCO, and outputs a rectangular wave signal BFO. The signal BFO is, for example, a rectangular wave signal having an amplitude of approximately 1.4 V_{P-P}.

A capacitor 22 is connected between the XD terminal and the ground. A capacitor 23 is connected between the XG terminal and the ground. Therefore, the capacitors 22 and 23 function as a load capacitance of the oscillation circuit 20 configured by the resonator 3 and the drive circuit 21. A capacitance formed between the electrode 101 and the electrode 102 of the sensing section 100 also functions as a load capacitance of the oscillation circuit 20. Until the grounded conductor 300 approaches the conductor 310, the capacitance value C_{L} of the load capacitance of the oscillation circuit 20 is composed of a capacitance value C₁ of the capacitor 22, a capacitance value C₂ of the capacitor 23, a capacitance value C₃ of a capacitance formed between the electrodes 101 and 102, and a stray capacitance C_{S}, as illustrated in Expression (3). The stray capacitance C_{S} is, for example, several pF. ${C}_{L} = \frac{{C}_{2} \times \left({C}_{1}+{C}_{3}\right)}{{C}_{2} + \left({C}_{1}+{C}_{3}\right)} + {C}_{s}$ (3)

On the other hand, the capacitance value C_{L} of the load capacitance of the oscillation circuit 20 obtained when the grounded conductor 300 approaches the conductor 310 is expressed by Expression (4) with reference to Expression (2). ${C}_{L} = \frac{{C}_{2} \times \left({C}_{L}^{′}+{C}_{1}+{C}_{3}\right)}{{C}_{2} + \left({C}_{L}^{′}+{C}_{1}+{C}_{3}\right)} + {C}_{s} = \frac{{C}_{2} \times \left(\frac{{C}_{D} {C}_{touch}}{{C}_{D} + {C}_{touch}}+{C}_{1}+{C}_{3}\right)}{{C}_{2} \times \left(\frac{{C}_{D} {C}_{touch}}{{C}_{D} + {C}_{touch}}+{C}_{1}+{C}_{3}\right)} + {C}_{s}$ (4)

According to Expression (3) and Expression (4), when the conductor 300 approaches the conductor 310, the capacitance value C_{L} of the oscillation circuit 20 increases.

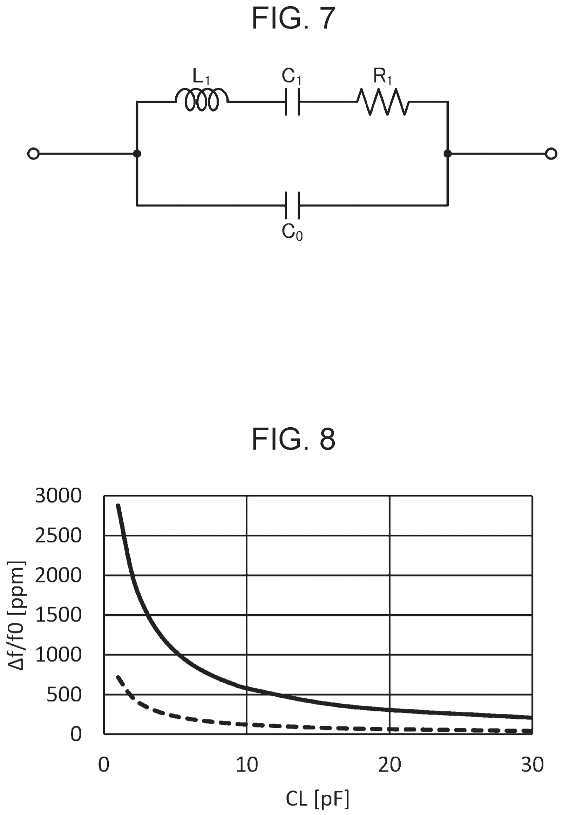

Here, FIG. 7 is a diagram illustrating an equivalent circuit of the resonator 3 which is a quartz crystal resonator, and examples of an equivalent constant of the resonator 3 include a series inductance L₁, the series capacitance C₁, a series resistance R₁, and a parallel capacitance C₀. Here, a series resonance frequency f₀ of the resonator 3 is expressed by Expression (5). ${f}_{0} = \frac{1}{2 π} \sqrt{\frac{1}{{L}_{1} {C}_{1}}}$ (5)

An oscillation frequency f of the oscillation circuit 20 constituted by the resonator 3 and the drive circuit 21 changes depending on the capacitance value C_{L} of the load capacitance, and a normalized frequency Δf/f₀ of the oscillation circuit 20 is expressed by Expression (6). $\frac{Δ f}{{f}_{0}} = \frac{f - {f}_{0}}{{f}_{0}} = \frac{1}{2 γ} \frac{1}{1 + \frac{{C}_{L}}{{C}_{0}}}$ (6)

In Expression (6), y is a ratio between the parallel capacitance C₀ and the series capacitance C₁, and is expressed by Expression (7). $γ = \frac{{C}_{0}}{{C}_{1}}$ (7)

FIG. 8 is a diagram illustrating an example of the relationship between the capacitance value C_{L} of the load capacitance and the normalized frequency Δf/f₀. In FIG. 8, a solid line is a graph obtained when the resonator 3 is a tuning fork type quartz crystal resonator, and a broken line is a graph obtained when the resonator 3 is an AT cut quartz crystal resonator. According to FIG. 8, when the capacitance value C_{L} of the load capacitance changes in a range from 0 pF to 30 pF, the normalized frequency Δf/f₀ also changes, and a rate of the change is larger in the tuning fork type quartz crystal resonator.

According to Expression (5) to Expression (7), when the capacitance value C_{L} of the load capacitance changes, the oscillation frequency f of the oscillation circuit 20 changes. A frequency of the oscillation signal OSCO output from the drive circuit 21 is the oscillation frequency f, and a frequency of the signal BFO output from the buffer circuit 30 also matches the oscillation frequency f.

As illustrated in FIG. 5, the measurement circuit 40 measures a frequency of the signal BFO output from the buffer circuit 30. That is, the measurement circuit 40 measures the oscillation frequency f. For example, the measurement circuit 40 includes a frequency divider circuit 41 and a counter 42.

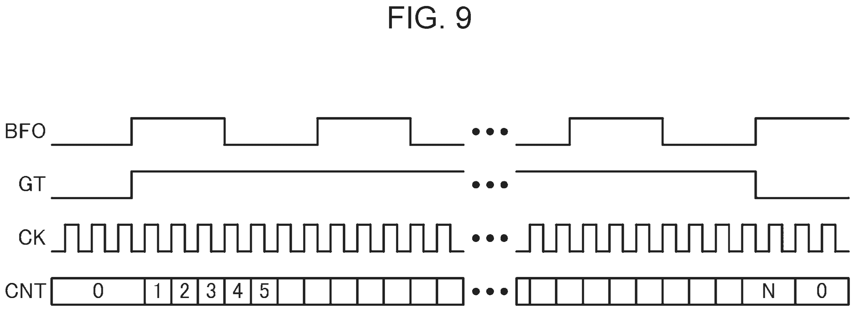

The frequency divider circuit 41 outputs a gate time signal GT obtained by dividing the frequency of the signal BFO. The counter 42 counts the number of pulses of a clock signal CK included in a gate time which is defined by the gate time signal GT, and outputs a count value CNT. For example, as illustrated in a timing chart of FIG. 9, the frequency divider circuit 41 outputs the gate time signal GT which is at a high level for a period of time of a predetermined cycle of the signal BFO, and the counter 42 outputs the count value CNT of the number of pulses of the clock signal CK included in the period of time in which the gate time signal GT is at the high level. In this case, the period of time in which the gate time signal GT is at the high level corresponds to the gate time.

The count value CNT corresponds to a ratio between a frequency of the clock signal CK and a frequency of the signal BFO, and the count value CNT decreases as the frequency of the signal BFO increases. That is, the frequency of the signal BFO and the count value CNT have a one to-one relationship, and the count value CNT corresponds to the frequency of the signal BFO, that is, the measurement value of the oscillation frequency f. The count value CNT is stored in the register 70.

The longer the gate time is, the higher a measurement resolution of the measurement circuit 40 is, but the longer a period of time required for the measurement is. Therefore, the gate time is appropriately set according to an upper limit value of an allowable measurement time, and is set to, for example, several hundred milliseconds.

The clock signal CK is output from the clock generation circuit 50. As a frequency of the clock signal CK increases, the measurement resolution of the measurement circuit 40 increases. Therefore, for example, the clock generation circuit 50 may be a ring oscillator capable of outputting a signal of several tens of MHz to several hundreds of MHz. In addition, the clock signal CK may be output from the clock generation circuit 50 in the gate time during which the gate time signal GT is at a predetermined logic level, for example, in a gate time during which the gate time signal GT is at a high level. Therefore, while the capacitance sensor 10 is operating, the clock signal CK may be continuously output from the clock generation circuit 50, but a period of time in which the output of the clock signal CK from the clock generation circuit 50 is stopped may be provided separately from the gate time. In this case, power consumption of the capacitance sensor 10 can be suppressed.

The control circuit 60 controls the operation of the oscillation circuit 20. For example, the control circuit 60 outputs an enabling signal to the oscillation circuit 20, and the oscillation circuit 20 oscillates when the enabling signal is at a high level and stops the oscillation when the enabling signal is at a low level. The control circuit 60 also controls the operation of the measurement circuit 40. For example, the control circuit 60 outputs a signal for instructing the measurement circuit 40 to start measurement, and the measurement circuit 40 performs a measurement process in response to the signal for instructing the measurement circuit 40 to start measurement.

The interface circuit 80 is used to perform data communication with the MCU 200. The interface circuit 80 may be, for example, an interface circuit of an SPI bus or an interface circuit of an I²C bus. SPI is an abbreviation for Serial Peripheral Interface, and I²C is an abbreviation for Inter-Integrated Circuit.

For example, when receiving a measurement request from the MCU 200, the interface circuit 80 rewrites a predetermined bit of the register 70 from 0 to 1. When detecting that the bit has been rewritten, the control circuit 60 causes the oscillation circuit 20 to start an oscillation operation, and outputs a signal for instructing the measurement circuit 40 to start measurement after a predetermined waiting time elapses. In addition, for example, when receiving a request for reading a measurement value from the MCU 200, the interface circuit 80 reads the count value CNT stored in the register 70 and transmits the count value CNT to the MCU 200. Note that the data communication between the control circuit 60 and MCU 200 via the interface circuit 80 may be wireless communication or wired communication.

The MCU 200 receives the count value CNT, calculates the oscillation frequency f of the oscillation circuit 20 based on the count value CNT, and detects approach of the conductor 300 to the conductor 310 based on a change in the oscillation frequency f. Then the MCU 200 may include a wireless communication module compliant with a standard, such as Wi-Fi^{®} or Bluetooth^{®}, and may transmit a wireless signal indicating that the approach of the conductor 300 to the conductor 310 is detected. For example, the MCU 200 may transmit the wireless signal to a control device mounted on the vehicle, and the control device may transmit information indicating the approach of the conductor 300 to the conductor 310 to a portable information terminal of a predetermined user, such as an owner of the vehicle, via a base station.

Note that the capacitance sensor 10 may include the MCU 200. That is, the capacitance sensor 10 may calculate the oscillation frequency f of the oscillation circuit 20 based on the count value CNT, and may detect the approach of the conductor 300 to the conductor 310 based on a change in the oscillation frequency f. Furthermore, the capacitance sensor 10 may include a wireless communication module that transmits a wireless signal indicating that the approach of the conductor 300 to the conductor 310 is detected. In this way, since a cable for transmitting a signal indicating that the approach of the conductor 300 to the conductor 310 is detected is not required, restriction on an installation location of the sensing device 1 is reduced.

Note that the conductor 310 is an example of a "first conductor", and the conductor 300 is an example of a "second conductor". The capacitance 401 is an example of a "first capacitance", and the capacitance 402 is an example of a "second capacitance". The surface 110a of the substrate 110 is an example of a "first surface", and the surface 110b of the substrate 110 is an example of a "second surface". The electrode 101 is an example of a "sensing electrode", and the electrode 102 is an example of a "ground electrode". The power supply voltage VDD is an example of a "first power supply voltage", and the power supply voltage VDDO is an example of a "second power supply voltage".

### 1-3. Operation and Effect

As described above, in the sensing device 1 of this embodiment, when the grounded conductor 300 approaches the conductor 310 in the capacitance sensor 10, the capacitance 402 is formed between the conductor 310 and the conductor 300, and the capacitances 401 and 402 are connected in series between the electrode 101 of the sensing section 100 and the ground. Therefore, the load capacitance of the oscillation circuit 20 changes, and the oscillation frequency f changes. That is, the capacitance sensor 10 detects the approach of the conductor 300 to the conductor 310 not by a change in a current but by a change in the oscillation frequency f. As described above, since the capacitance sensor 10 detects a slight change in the load capacitance of the oscillation circuit 20 as a change in the oscillation frequency f instead of a change in a current, the detection sensitivity does not depend on a voltage or a current value. Therefore, it is only necessary to cause a current of a magnitude necessary for oscillation to flow through the oscillation circuit 20, so that power consumption can be reduced.

Furthermore, according to the sensing device 1 of this embodiment, in the capacitance sensor 10, the power supply voltage VDDO supplied to the amplifier 211 is lower than the power supply voltage VDD supplied to the VDD terminal, and the voltage amplitude of the signal output from the amplifier 211 is lower than the power supply voltage VDDO. Therefore, the power consumed by the amplifier 211 is reduced. To be specific, a consumption current I due to the capacitance value C_{L} of the load capacitance of the oscillation circuit 20 is expressed by Expression (8). $I = 2 {πC}_{L} \times {V}_{PP} \times f$ (8)

In Expression (8), a voltage V_{PP} is a voltage amplitude of the signal output from the amplifier 211, and f is the oscillation frequency of the oscillation circuit 20. As described above, the power supply voltage VDDO supplied to the amplifier 211 is 1 V, but the voltage amplitude of the signal output from the amplifier 211 is approximately 0.4 V, so that the current consumption is reduced.

In addition, in the sensing device 1 of this embodiment, since the capacitance sensor 10 can operate with low power consumption, it is difficult to radiate noise to the outside. Furthermore, since the resonator 3 serves as a filter in the capacitance sensor 10, EMI resistance to external noise is high.

Moreover, in the sensing device 1 of this embodiment, in the capacitance sensor 10, the oscillation circuit 20 oscillates based on the resonance by the resonator 3 and the capacitance, not CR oscillation based on charge and discharge of a capacitance. Therefore, the oscillation circuit 20 is hardly affected by the external amplitude noise. Therefore, according to the sensing device 1 of this embodiment, the capacitance sensor 10 can detect the oscillation frequency f with high accuracy.

Furthermore, in the sensing device 1 of this embodiment, in the capacitance sensor 10, the resonator 3 has a very high Q value and thus also functions as a noise filter, noise input from the SD terminal connected to the output node ND of the amplifier 211 is greatly reduced by the resonator 3, and a signal output from the resonator 3 to the input node NG of the amplifier 211 has little noise and is a signal close to a sine wave. Therefore, according to the sensing device 1 of this embodiment, since a spike due to noise does not occur in the output signal of the buffer circuit 30 in the capacitance sensor 10, the possibility that the measurement circuit 40 performs erroneous measurement is reduced.

In addition, in the sensing device 1 of this embodiment, since the electrode 102 is disposed on the surface 110b of the substrate 110 at a position facing the region of the arrangement of the electrode 101 on the surface 110a in the capacitance sensor 10, when a conductor that is not a detection target is positioned to face the surface 110b, the influence of the conductor on the load capacitance of the oscillation circuit 20 is reduced. Therefore, according to the sensing device 1 of this embodiment, it is possible to improve the detection accuracy of the oscillation frequency f by the capacitance sensor 10.

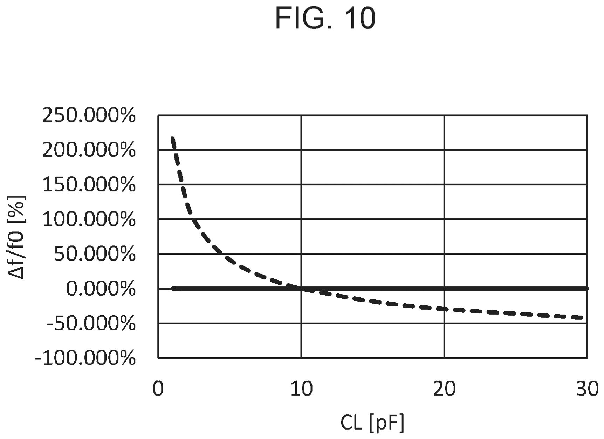

Meanwhile, as illustrated in FIG. 10, an LC oscillation circuit using an LC resonance constituted by an inductor and a capacitance has a wide variable width of an oscillation frequency compared to an oscillation circuit using a resonator and a capacitance. FIG. 10 is a diagram illustrating an example of the relationship between the capacitance value C_{L} of the load capacitance and the normalized frequency Δf/f₀. A solid line is a graph in a case where the resonator 3 is a tuning fork type quartz crystal resonator, and corresponds to the solid line graph of FIG. 8. A broken line is a graph in the case of an LC oscillation circuit. As is apparent from FIG. 10, it is understood that a variable width of the oscillation circuit using a resonator and a capacitance is extremely narrow as compared with the variable width of the oscillation frequency of the LC oscillation circuit.

Therefore, it is also considered to configure a capacitance sensor having high detection sensitivity using the LC oscillation circuit. However, for example, in a case where a capacitance of the pF order is detected by the capacitance sensor 10 using the LC oscillation circuit, when a small-sized inductor of the nH order is used in order to realize cost reduction, an oscillation frequency becomes the GHz order, and various problems, such as an increase in size or power consumption of the circuit for measuring an oscillation frequency, may occur. On the other hand, in order to set the oscillation frequency to the MHz order, an inductor having a large size of the µH order is required to be used, which is an obstacle to the reduction in size and cost of the capacitance sensor.

On the other hand, in the sensing device 1 of this embodiment, in the capacitance sensor 10, the oscillation circuit 20 using the resonator 3 and the capacitance has a considerably narrower variable width of the oscillation frequency f than the LC oscillation circuit, but the oscillation frequency f of the kHz order or the MHz order can be easily realized by using the small resonator 3, and for example, for the capacitance of the pF order, a variable width of the oscillation frequency f necessary for practical use can be obtained as illustrated in FIG. 8. Furthermore, since an inductance value of an inductor is determined by a size, it is difficult to reduce the size of the inductor without changing the inductance value. On the other hand, in the resonator 3, further miniaturization and cost reduction can be realized by the progress of the manufacturing process in the future. Therefore, since it is possible to realize a reduction in size and a reduction in cost of the capacitance sensor 10 compared to a capacitance sensor using an LC oscillation circuit, for example, the capacitance sensor 10 can be easily used even when the detection target is the small conductor 300.

### 2. Modifications

The present disclosure is not limited to this embodiment, and various modifications may be made without departing from the scope of the present disclosure.

For example, in the above-described embodiment, the electrode 101 of the sensing section 100 is connected to the output node ND of the amplifier 211, but may be connected to the input node NG of the amplifier 211.

In the embodiment described above, the circuit device 2 measures the oscillation frequency f based on the signal BFO and outputs the measurement value of the oscillation frequency f to the outside of the capacitance sensor 10, but may output the signal BFO to the outside. Then, the external device may measure the oscillation frequency f which is the frequency of the signal BFO. In this case, the circuit device 2 does not necessarily include the measurement circuit 40. Alternatively, the circuit device 2 may calculate the capacitance value C_{L} of the load capacitance based on the oscillation frequency f and output the capacitance value C_{L} to the outside.

In addition, the capacitance sensor 10 of the embodiment described above is a simple capacitance sensor, such as an SPXO, but may be a capacitance sensor having a temperature compensation function, such as a TCXO, or may be a capacitance sensor having a frequency control function, such as a VCXO. SPXO is an abbreviation for Simple Packaged Crystal Oscillator. TCXO is an abbreviation for Temperature Compensated Crystal Oscillator. VCXO is an abbreviation for Voltage Controlled Crystal Oscillator. Furthermore, the capacitance sensor 10 may be a capacitance sensor having a temperature compensation function and a frequency control function, such as a VC-TCXO, or may be a capacitance sensor having a temperature control function, such as an OCXO. VC-TCXO is an abbreviation for Voltage Controlled Temperature Compensated Crystal Oscillator. Furthermore, OCXO is an abbreviation of Oven Controlled Crystal Oscillator.

The above-described embodiment and modifications are merely examples, and the present disclosure is not limited thereto. For example, each of the embodiment and the modifications may be combined as appropriate.

The present disclosure includes configurations that are substantially the same as the configurations described in the embodiment, for example, a configuration having the same function, method, and result as those in the embodiment, or a configuration having the same purposes and effects as those in the embodiment. In addition, the present disclosure includes configurations in which non-essential components of the configurations described in the embodiment are replaced. In addition, the present disclosure includes configurations that produce the same operational effects as those of the configurations described in the embodiment or configurations that can achieve the same objects as those of the configurations described in the embodiment. Furthermore, the present disclosure includes configurations in which a known technique is added to the configurations described in the embodiment.

The following contents are derived from the above-described embodiment and the modifications.

According to an aspect of the capacitance sensor, the capacitance sensor is connected to a sensing electrode forming a first capacitance between the sensing electrode and a first conductor and includes a package, a sensing terminal disposed in the package and electrically connected to the sensing electrode, and an oscillation circuit included in the package. The oscillation circuit includes an amplifier, and a resonator connected between an input node and an output node of the amplifier. The sensing terminal is connected to one of the input node and the output node of the amplifier. When a grounded second conductor approaches the first conductor, a second capacitance is formed between the first conductor and the second conductor, and the first capacitance and the second capacitance are connected in series between the sensing electrode and the ground so that an oscillation frequency of the oscillation circuit is changed.

In the capacitance sensor, when the grounded second conductor approaches the first conductor, the second capacitance is formed between the first conductor and the second conductor, and the first capacitance and the second capacitance are connected in series between the sensing electrode and the ground so that a load capacitance of the oscillation circuit is changed and an oscillation frequency of the oscillation circuit is changed. That is, the capacitance sensor detects the approach of the second conductor to the first conductor not by a change in a current but by a change in the oscillation frequency. As described above, since the capacitance sensor detects a slight change in the load capacitance of the oscillation circuit as a change in the oscillation frequency f instead of a change in a current, the detection sensitivity does not depend on a voltage or a current value. Therefore, it is only necessary to cause a current of a magnitude necessary for oscillation to flow through the oscillation circuit, so that power consumption can be reduced.

In addition, since the capacitance sensor can operate with low power consumption, it is difficult to radiate noise to the outside. Furthermore, since the resonator serves as a filter in the capacitance sensor, EMI resistance to external noise is high.

Moreover, in the capacitance sensor, since the oscillation circuit oscillates based on a resonance between the resonator and the capacitance instead of the CR oscillation based on charging and discharging of the capacitance, the oscillation circuit is not easily affected by external amplitude noise. Therefore, according to the capacitance sensor, it is possible to detect the oscillation frequency with high accuracy.

Meanwhile, since an LC oscillation circuit using an LC resonance generated by an inductor and a capacitance has a wide variable width of an oscillation frequency as compared to an oscillation circuit using a resonator and a capacitance, it is also considered to configure a sensing device having high detection sensitivity using the LC oscillation circuit. However, for example, in a case where a change in an oscillation frequency by the second capacitance of the pF order is detected by the capacitance sensor using the LC oscillation circuit, when a small-sized inductor of the nH order is used in order to realize cost reduction, an oscillation frequency becomes the GHz order, and various problems, such as an increase in size or power consumption of the circuit for measuring the oscillation frequency, may occur. On the other hand, in order to set the oscillation frequency to the MHz order, an inductor having a large size of the µH order is required to be used, which is an obstacle to the reduction in size and cost of the capacitance sensor.

On the other hand, although the oscillation circuit using the resonator and the capacitance has a considerably narrower variable width of the oscillation frequency than the LC oscillation circuit, it is possible to easily realize an oscillation frequency of the kHz order or the MHz order by using a small-sized resonator, and for example, it is possible to obtain a variable width of the oscillation frequency required for practical use with respect to the capacitance of the pF order. Furthermore, since an inductance value of the inductor is determined by size, it is difficult to reduce a size of the inductor without changing an inductance value. On the other hand, in the resonator, further miniaturization and cost reduction can be realized by the progress of a manufacturing process in the future. Therefore, according to the capacitance sensor, it is possible to realize a reduction in size and a reduction in cost as compared to a capacitance sensor using an LC oscillation circuit.

In the aspect of the capacitance sensor, the sensing terminal may be connected to the output node of the amplifier.

In the capacitance sensor, since the resonator has a very high Q factor and therefore also functions as a noise filter, noise input from the sensing terminal connected to the output node of the amplifier is greatly reduced by the resonator, and the signal output from the resonator to the input node of the amplifier is a signal with little noise and close to a sine wave. Therefore, according to the capacitance sensor, it is possible to reduce a concern that detection accuracy is deteriorated due to noise input from the sensing electrode connected to the sensing terminal.

In the aspect of the capacitance sensor, the capacitance sensor may further include a buffer circuit to which a signal output from the resonator to the input node of the amplifier is input, and a measurement circuit that measures a frequency of a signal output from the buffer circuit.

In the capacitance sensor, the resonator has a very high Q factor and therefore also functions as a noise filter, and the signal output from the resonator to the input node of the amplifier is a signal with little noise and close to a sine wave. Therefore, according to the capacitance sensor, since a spike due to noise does not occur in the output signal of the buffer circuit, the possibility that the measurement circuit performs erroneous measurement is reduced.

In the aspect of the capacitance sensor, the capacitance sensor may further include a ground terminal disposed in the package. The sensing electrode may be disposed on a first surface of a substrate. A ground electrode may be disposed, on a second surface which is a back surface of the first surface of the substrate, at a position facing an arrangement region of the sensing electrode on the first surface, and the ground terminal may be electrically connected to the ground electrode.

In the capacitance sensor, since the ground electrode is disposed on the second surface of the substrate at a position facing the region of the arrangement of the sensing electrode on the first surface, when a conductor that is not a detection target is positioned to face the second surface, the influence of the conductor on the load capacitance of the oscillation circuit is reduced. Therefore, according to the capacitance sensor, it is possible to improve the detection accuracy of the oscillation frequency.

In the aspect of the capacitance sensor, the capacitance sensor further may include a power supply terminal that is disposed in the package and supplied with a first power supply voltage, and a regulator that steps down the first power supply voltage to a second power supply voltage that is lower than the first power supply voltage. The amplifier may be supplied with the second power supply voltage.

According to the capacitance sensor, since the second power supply voltage supplied to the amplifier is lower than the first power supply voltage supplied to the power supply terminal, power consumed by the amplifier is reduced.

In the aspect of the capacitance sensor, a voltage amplitude of a signal output from the amplifier may be lower than the second power supply voltage.

According to the capacitance sensor, since the voltage amplitude of the signal output from the amplifier is lower than the second power supply voltage, power consumption is reduced.

In the aspect of the capacitance sensor, the capacitance sensor may further include a wireless communication module that detects approach of the second conductor to the first conductor based on a change in the oscillation frequency and transmits a wireless signal indicating that the approach of the second conductor to the first conductor is detected.

According to the capacitance sensor, since a cable for transmitting a signal indicating that the approach of the second conductor to the first conductor is detected is not required, restriction on an installation location is reduced.

In the aspect of the capacitance sensor, the first conductor may be a metal plate included in a door of a vehicle.

According to the capacitance sensor, it is possible to detect approach of the second conductor to the vehicle by a change in the oscillation frequency.

In the aspect of the capacitance sensor, the second conductor may be a person.

According to the capacitance sensor, it is possible to detect approach of a person to the first conductor by a change in the oscillation frequency.

In the aspect of the sensing device, the sensing device includes the capacitance sensor according to the aspect and the sensing electrode.

According to the sensing device, it is possible to detect approach of the second conductor to the first conductor with low power consumption.

## Claims

1. A capacitance sensor connected to a sensing electrode forming a first capacitance between the sensing electrode and a first conductor, the capacitance sensor comprising:
a package;
a sensing terminal disposed in the package and electrically connected to the sensing electrode; and
an oscillation circuit included in the package, wherein
the oscillation circuit includes
an amplifier, and
a resonator connected between an input node and an output node of the amplifier,
the sensing terminal is connected to one of the input node and the output node of the amplifier, and
when a grounded second conductor approaches the first conductor, a second capacitance is formed between the first conductor and the second conductor, and the first capacitance and the second capacitance are connected in series between the sensing electrode and the ground so that an oscillation frequency of the oscillation circuit is changed.

2. The capacitance sensor according to claim 1, wherein
the sensing terminal is connected to the output node of the amplifier.

3. The capacitance sensor according to claim 1 or 2, further comprising:
a buffer circuit to which a signal output from the resonator to the input node of the amplifier is input; and
a measurement circuit that measures a frequency of a signal output from the buffer circuit.

4. The capacitance sensor according to any one of the preceding claim 1 to claim 3, further comprising:
a ground terminal disposed in the package, wherein
the sensing electrode is disposed on a first surface of a substrate,
a ground electrode is disposed, on a second surface which is a back surface of the first surface of the substrate, at a position facing an arrangement region of the sensing electrode on the first surface, and
the ground terminal is electrically connected to the ground electrode.

5. The capacitance sensor according to any one of the preceding claim 1 to claim 4, further comprising:
a power supply terminal that is disposed in the package and supplied with a first power supply voltage; and
a regulator that steps down the first power supply voltage to a second power supply voltage that is lower than the first power supply voltage, wherein
the amplifier is supplied with the second power supply voltage.

6. The capacitance sensor according to claim 5, wherein
a voltage amplitude of a signal output from the amplifier is lower than the second power supply voltage.

7. The capacitance sensor according to any one of the preceding claim 1 to claim 6, further comprising:
a wireless communication module that detects approach of the second conductor to the first conductor based on a change in the oscillation frequency and transmits a wireless signal indicating that the approach of the second conductor to the first conductor is detected.

8. The capacitance sensor according to any one of the preceding claim 1 to claim 7, wherein
the first conductor is a metal plate included in a door of a vehicle.

9. The capacitance sensor according to any one of the preceding claim 1 to claim 8, wherein
the second conductor is a person.

10. A sensing device comprising:
the capacitance sensor according to any one of the preceding claim 1 to claim 9; and
the sensing electrode.
